(19) Europäisches Patentamt

European Patent Office

Office européen des brevets

(11) **EP 4 707 838 A1**

(12) **EUROPEAN PATENT APPLICATION**
published in accordance with Art. 153(4) EPC

(43) Date of publication:
**11.03.2026 Bulletin 2026/11**

(21) Application number: **25745496.7**

(22) Date of filing: **02.01.2025**

(51) International Patent Classification (IPC):
***G01R 31/396*** (2019.01)      ***G01R 31/382*** (2019.01)
***G01R 31/392*** (2019.01)

(52) Cooperative Patent Classification (CPC):
**G01R 31/382; G01R 31/392; G01R 31/396;**
**Y02E 60/10**

(86) International application number:
**PCT/KR2025/000043**

(87) International publication number:
**WO 2025/159388 (31.07.2025 Gazette 2025/31)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **25.01.2024 KR 20240011541**

(71) Applicant: **LG Energy Solution, Ltd.**
**Seoul 07335 (KR)**

(72) Inventors:
• **CHOI, Hyun-Jun**
  **Daejeon 34122 (KR)**
• **KIM, Young-Deok**
  **Daejeon 34122 (KR)**
• **KIM, Tae-Hyeon**
  **Daejeon 34122 (KR)**

(74) Representative: **Goddar, Heinz J.**
**Boehmert & Boehmert**
**Anwaltspartnerschaft mbB**
**Pettenkoferstrasse 22**
**80336 München (DE)**

(54) **BATTERY DIAGNOSTIC DEVICE AND METHOD**

(57)     A method for diagnosing a battery according to one aspect of the present disclosure includes: generating a battery profile representing a relationship between a capacity and a voltage of the target battery for each predetermined number of charge cycles or discharge cycles; obtaining a negative electrode profile estimating a relationship between a negative electrode capacity and a negative electrode potential of the target battery based on the battery profile; obtaining a diagnostic factor value representing an available capacity per unit area of the negative electrode based on the negative electrode profile; and diagnosing a state of the negative electrode based on diagnostic factor values sequentially obtained as the charge cycle or the discharge cycle is repeated.

FIG. 1

EP 4 707 838 A1

**Description**

TECHNICAL FIELD

This application is based on and claims priority from Korean Patent Application No. 10-2024-0011541, filed on January 25, 2024, with the Korean Intellectual Property Office, the disclosure of which is incorporated herein in its entirety by reference.

The present disclosure relates to an apparatus and method for diagnosing a battery, and more particularly, to an apparatus and method for non-destructively diagnosing a state of a battery capable of charging and discharging.

BACKGROUND ART

Recently, the demand for portable electronic products such as notebook computers, digital cameras and portable telephones has increased sharply, and electric vehicles, energy storage systems, robots, satellites and the like have been developed in earnest. Accordingly, high-performance batteries allowing charging and discharging are being actively studied.

Types of rechargeable batteries include lithium batteries that use lithium ions, such as lithium-ion batteries or lithium-ion polymer batteries, and nickel cadmium batteries, nickel hydrogen batteries, and nickel zinc batteries. Among these, lithium batteries have the advantages of having a relatively long lifespan, a very low self-discharge rate, and high energy density because they have almost no memory effect compared to batteries that use nickel, and thus their application range is gradually expanding.

The positive electrode and negative electrode of these batteries gradually deteriorate as the charge and discharge cycles are repeated, and they no longer maintain the electrical capacity they had at the time of manufacture but are deteriorated. Therefore, in order to accurately predict the usable time, remaining life, and replacement time of the battery, an accurate diagnosis of the battery state is required.

However, since the existing technology diagnoses the battery through the SOH (State of Health) of the entire battery, there is a problem in that the state of the negative electrode cannot be diagnosed separately from the state of the positive electrode of the battery when an active material that undergoes phase transformation, such as pure silicon (Pure Si), is applied to the negative electrode of the battery. The reason is that the active material that undergoes phase transformation as charge and discharge progresses is not degraded as charge and discharge are repeated, but rather may provide more available capacity.

DISCLOSURE

Technical Problem

The technical challenge that the present disclosure seeks to solve is to provide an apparatus and method for diagnosing a battery, which may diagnose a state of a negative electrode separately from a state of a positive electrode of a target battery, even when an active material that undergoes phase transformation, such as pure silicon, is applied to the corresponding negative electrode of the target battery.

Another technical challenge that the present disclosure seeks to solve is to provide an apparatus and method for diagnosing a battery, which may accurately diagnose the degree of activation or degradation of the negative electrode of the target battery, thereby delaying the degradation of the negative electrode.

Another technical challenge that the present disclosure seeks to solve is to provide a battery pack including the apparatus for diagnosing a battery.

Another technical challenge that the present disclosure seeks to solve is to provide a vehicle including the apparatus for diagnosing a battery.

Technical Solution

A method for diagnosing a battery according to one aspect of the present disclosure diagnoses a target battery having a negative electrode to which an active material that undergoes phase transformation as charge and discharge progresses is applied, and comprises: generating a battery profile representing a relationship between a capacity and a voltage of the target battery for each predetermined number of charge cycles or discharge cycles; obtaining a negative electrode profile estimating a relationship between a negative electrode capacity and a negative electrode potential of the target battery based on the battery profile; obtaining a diagnostic factor value representing an available capacity per unit area of the negative electrode based on the negative electrode profile; and diagnosing a state of the negative electrode based on diagnostic factor values sequentially obtained as the charge cycle or the discharge cycle is repeated.

In an embodiment, the method for diagnosing a battery may further comprise, before the step of generating a battery profile: measuring a voltage value of the target battery using a voltage sensor while the predetermined number of charge cycles or discharge cycles progress.

In an embodiment, the method for diagnosing a battery may further comprise, before the step of obtaining a negative electrode profile: generating a plurality of adjusted positive electrode profiles differently adjusted and a plurality of adjusted negative electrode profiles differently adjusted by adjusting a reference positive electrode profile representing a relationship between a positive electrode capacity and a positive electrode potential of a predetermined reference battery and a reference negative electrode profile representing a relationship between a negative electrode capacity and a negative electrode potential of the reference battery, respectively, and the step of obtaining a negative electrode profile may include a step of selecting an adjusted positive electrode profile and an adjusted negative electrode profile corresponding to the battery profile among the plurality of adjusted positive electrode profiles and the plurality of adjusted negative electrode profiles, and obtaining the selected adjusted negative electrode profile as the negative electrode profile of the target battery.

In an embodiment, the step of obtaining a diagnostic factor value may include a step of calculating the diagnostic factor value based on a negative electrode shrinkage ratio, which represents a degree of shrinkage of the negative electrode profile compared to a reference negative electrode profile representing a relationship between a negative electrode capacity and a negative electrode potential of a predetermined reference battery, and a predetermined reference value for the diagnostic factor.

In an embodiment, the step of diagnosing a state of the negative electrode may include a step of diagnosing that degradation of the negative electrode is in progress when the diagnostic factor values show a trend of increasing and then decreasing for a predetermined period or longer as the charge cycle or the discharge cycle is repeated.

In an embodiment, the step of diagnosing a state of the negative electrode may include: determining a maximum value among the diagnostic factor values; and diagnosing the state of the negative electrode as an abnormal state when another diagnostic factor value obtained after an acquisition time point of the diagnostic factor value corresponding to the maximum value is less than a predetermined threshold value.

In an embodiment, the method for diagnosing a battery may further comprise, after the step of diagnosing a state of the negative electrode: adjusting a charging condition or a discharging condition of the target battery based on the diagnosis result of the state of the negative electrode.

In an embodiment, the active material may be silicon.

An apparatus for diagnosing a battery according to another aspect of the present disclosure diagnoses a target battery having a negative electrode to which an active material that undergoes phase transformation as charge and discharge progresses is applied, and comprises a battery profile generating unit configured to generate a battery profile representing a relationship between a capacity and a voltage of the target battery for each predetermined number of charge cycles or discharge cycles; a negative electrode profile obtaining unit configured to obtain a negative electrode profile estimating a relationship between a negative electrode capacity and a negative electrode potential of the target battery based on the battery profile; a diagnostic factor obtaining unit configured to obtain a diagnostic factor value representing an available capacity per unit area of the negative electrode based on the negative electrode profile; and a diagnosing unit configured to diagnose a state of the negative electrode based on diagnostic factor values sequentially obtained by the diagnostic factor obtaining unit as the charge cycle or the discharge cycle is repeated.

In an embodiment, the negative electrode profile obtaining unit may include a first module for generating a plurality of adjusted positive electrode profiles differently adjusted and a plurality of adjusted negative electrode profiles differently adjusted by adjusting a reference positive electrode profile representing a relationship between a positive electrode capacity and a positive electrode potential of a predetermined reference battery and a reference negative electrode profile representing a relationship between a negative electrode capacity and a negative electrode potential of the reference battery, respectively; and a second module for selecting an adjusted positive electrode profile and an adjusted negative electrode profile corresponding to the battery profile among the plurality of adjusted positive electrode profiles and the plurality of adjusted negative electrode profiles, and obtaining the selected adjusted negative electrode profile as the negative electrode profile of the target battery.

In an embodiment, the diagnosing unit may be configured to diagnose that degradation of the negative electrode is in progress when the diagnostic factor values show a trend of increasing and then decreasing for a predetermined period or longer as the charge cycle or the discharge cycle is repeated.

In an embodiment, the diagnosing unit may be configured to diagnose the state of the negative electrode as an abnormal state when another diagnostic factor value obtained after an acquisition time point of a diagnostic factor value corresponding to a maximum value among the diagnostic factor values is less than a predetermined threshold value.

A battery pack according to still another aspect of the present disclosure may comprise the apparatus for diagnosing a battery as described above.

A vehicle according to still another aspect of the present disclosure may comprise the apparatus for diagnosing a battery as described above.

Advantageous Effects

According to the present disclosure, the apparatus for diagnosing a battery is configured to generate a battery profile representing a relationship between the capacity and voltage of the target battery for each predetermined number of charge cycles or discharge cycles, obtain a negative electrode profile estimating a relationship between the negative electrode capacity and negative electrode potential of the target battery based on the generated battery profile, and diagnose the state of the negative electrode of the target battery based on diagnostic factor values obtained from the negative electrode profile. Accordingly, even when an active material that undergoes phase transformation, such as pure silicon, is applied to the negative electrode of the target battery, the state of the negative electrode may be diagnosed separately from the state of the positive electrode of the target battery.

In addition, the apparatus for diagnosing a battery is configured to accurately diagnose the degree of activation or degradation of the negative electrode of the target battery and adjust the charge and/or discharging condition of the target battery according to the diagnosis result, thereby delaying the degradation of the negative electrode of the target battery and extending its lifespan.

Furthermore, a person having ordinary skill in the art to which the present disclosure belongs will be able to clearly understand from the following description that various embodiments according to the present disclosure can solve various technical problems not mentioned above.

DESCRIPTION OF DRAWINGS

FIG. 1 is a block diagram showing an apparatus for diagnosing a battery according to an embodiment of the present disclosure.

FIG. 2 is a graph showing capacity and resistance of the battery that change according to the number of charge and discharge cycles.

FIG. 3 is a diagram showing a reference positive electrode profile and a reference negative electrode profile corresponding to a predetermined reference battery profile.

FIG. 4 is a diagram showing a battery profile of a target battery.

FIG. 5 is a diagram showing a first process of setting four points to correspond to a voltage range of interest during a combination profile generation procedure according to an embodiment of the present disclosure.

FIG. 6 is a drawing showing a second process of performing profile shift during the combination profile generation procedure.

FIG. 7 is a drawing showing a third process of performing capacity scaling during the combination profile generation procedure.

FIG. 8 is a drawing showing a fourth process of performing capacity scaling during the combination profile generation procedure according to another embodiment of the present disclosure.

FIG. 9 is a drawing showing a fifth process of setting four points during the combination profile generation procedure.

FIG. 10 is a drawing showing a sixth process of performing profile shift during the combination profile generation procedure.

FIG. 11 is a flow chart showing a method for diagnosing a battery according to an embodiment of the present disclosure.

FIG. 12 is a drawing showing a battery pack according to an embodiment of the present disclosure.

FIG. 13 is a drawing showing a vehicle according to an embodiment of the present disclosure.

BEST MODE

Hereinafter, in order to clarify the solution corresponding to the technical challenge of the present disclosure, embodiments according to the present disclosure will be described in detail with reference to the attached drawings. However, when explaining the present disclosure, if a description of a related publicly known technology obscures the gist of the present disclosure, the description thereof may be omitted.

In addition, the terms used in this specification are terms defined in consideration of the functions in the present disclosure, and these may vary depending on the intention or custom of the designer, manufacturer, etc. Therefore, the definitions of the terms described below should be made based on the contents throughout this specification.

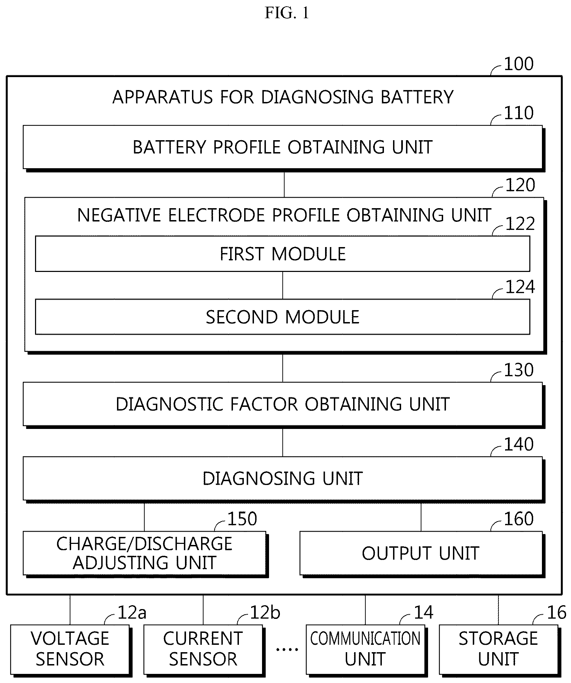

FIG. 1 is a block diagram showing an apparatus 100 for diagnosing a battery according to an embodiment of the present disclosure.

As illustrated in FIG. 1, the apparatus 100 for diagnosing a battery according to an embodiment of the present disclosure is a device configured to diagnose a state of a battery allowing charging and discharging, and includes a battery profile generating unit 110, a negative electrode profile obtaining unit 120, a diagnostic factor obtaining unit 130, and a diagnosing unit 140.

The battery (hereinafter, 'target battery') that is to be diagnosed by the apparatus 100 for diagnosing a battery according to the present disclosure may be a battery cell corresponding to a basic unit of charge and discharge, a battery module in which a plurality of battery cells are connected in series and/or in parallel, or a battery pack in which a plurality of battery cells or a plurality of battery modules are connected in series and/or in parallel.

In this case, the target battery may include an electrode assembly in which a positive electrode and a negative electrode are mutually stacked with a separator between them, and a case that accommodates the electrode assembly together with an electrolyte material.

Meanwhile, the positive electrode of the electrode assembly may include a positive electrode substrate made of a material including aluminum, and a positive electrode active material applied to the positive electrode substrate. The positive electrode active material may include a lithium-based oxide. The positive electrode active material may be applied to the positive electrode substrate together with a conductive material, a binder, and the like.

In addition, the negative electrode of the electrode assembly may include a negative electrode substrate made of a material including copper, and a negative electrode active material applied to the negative electrode substrate. The negative electrode active material may include a silicon-based material such as silicon (Si) or silicon oxide ($SiO_x$), or may include graphite together with the silicon-based material. The negative electrode active material may be applied to the negative electrode substrate together with a conductive material, a binder, and the like.

In particular, in an embodiment of the present disclosure, the negative electrode active material may be pure silicon (Pure Si). Pure silicon is a material that undergoes a phase transformation or allotropic transformation from a crystalline state to an amorphous state when activation proceeds after the manufacturing of the target battery. This phase transformation of pure silicon may be confirmed through EBSD (Electron Backscattered Diffraction) analysis.

Since the battery with the negative electrode to which pure silicon is applied has a considerably large NP ratio, the ratio of the area used for charge and discharge among the entire area of the negative electrode is relatively small compared to the positive electrode. Therefore, the negative electrode to which pure silicon is applied is used only in a part of the area for charge and discharge, and the area used is activated as a phase transformation from crystalline to amorphous occurs. In addition, the use area of the negative electrode to which pure silicon is applied gradually changes as the charge and discharge cycle progresses.

In this way, when an active material that undergoes phase transformation is applied to the negative electrode of the target battery, it is difficult to accurately diagnose the state of the target battery. This is because the active material that undergoes phase transformation as charge and discharge progresses is not degraded as charge and discharge are repeated, but rather may provide more available capacity.

Table 1 below shows the negative electrode loading amount (N loading) and available lithium loss of a battery with a negative electrode to which pure silicon is applied according to the number of charge and discharge cycles.

[Table 1]

| Number of cycles | n-loading [mAh/cm$^2$] | available lithium loss [%] |
|---|---|---|
| BOL | 6.01 | 0.0 |
| 300 | 7.92 | 1.82 |

In Table 1, BOL represents the BOL (Beginning of Life) point of the target battery, and n-loading represents the negative electrode loading amount of the target battery, i.e., the available capacity per unit area of the negative electrode. As shown in Table 1, as the number of charge and discharge cycles of the target battery increases up to 300, the negative electrode capacity of the target battery increases, while the positive electrode capacity of the target battery may decrease due to the available lithium loss. Therefore, the change in the overall capacity of the target battery according to the increase in charge and discharge cycles appears in a different pattern from the change in the negative electrode capacity of the target battery.

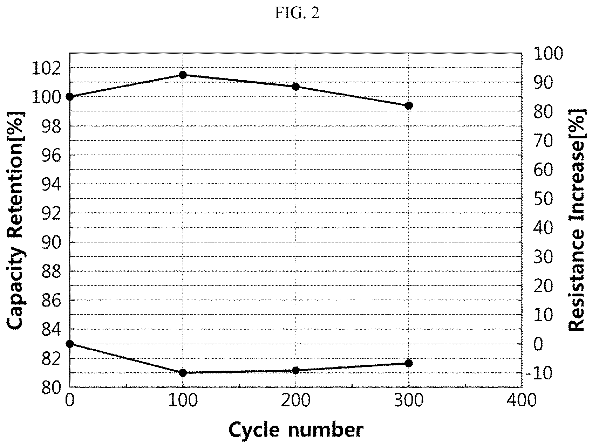

FIG. 2 is a graph showing capacity and resistance of the target battery that change according to the number of charge and discharge cycles.

As shown in FIG. 2, the total capacity of the target battery with the negative electrode to which pure silicon is applied shows a trend of increasing up to the 100th cycle and then gradually decreasing. In addition, the resistance of the target battery shows a trend of decreasing up to the 100th cycle and then increasing. In other words, the change in the total capacity of the target battery according to the increase in charge and discharge cycles appears in a different pattern from the change in the negative electrode capacity of the target battery.

Therefore, in order to accurately diagnose the state of the target battery, it is necessary to diagnose the state of the negative electrode separately from the state of the positive electrode.

The apparatus 100 for diagnosing a battery according to the present disclosure is configured to diagnose a battery having a negative electrode to which an active material that undergoes phase transformation as charge and discharge progresses is applied.

Referring again to FIG. 1, the battery profile generating unit 110 of the apparatus 100 for diagnosing a battery is configured to generate a battery profile representing a relationship between the capacity and voltage of the target battery for each predetermined number of charge cycles or discharge cycles.

In an embodiment, the battery profile generating unit 110 may be configured to measure voltage values according to the capacity of a target battery using a voltage sensor 12a while a predetermined number of charge cycles or discharge cycles are in progress, and generate the battery profile based on the measured voltage values.

For reference, the current capacity of the target battery may be calculated by applying the current integration method to the charge current or discharge current of the target battery. To this end, the battery profile generating unit 110 may be linked to a current sensor 12b that senses the charge current or discharge current of the target battery, or include the current sensor 12b.

The negative electrode profile obtaining unit 120 is configured to obtain a negative electrode profile that estimates a relationship between the negative electrode capacity and the negative electrode potential of the target battery based on the battery profile. To this end, the negative electrode profile obtaining unit 120 may include a first module 122 and a second module 124.

In this case, the first module 122 may be configured to generate a plurality of adjusted positive electrode profiles differently adjusted and a plurality of adjusted negative electrode profiles differently adjusted by adjusting a reference positive electrode profile representing a relationship between a positive electrode capacity and a positive electrode potential of a predetermined reference battery and a reference negative electrode profile representing a relationship between a negative electrode capacity and a negative electrode potential of the reference battery, respectively. For reference, the reference battery may be a target battery at the BOL (Beginning of Life) time point, or a battery in a normal state with the same configuration as the target battery.

The second module 124 may be configured to select an adjusted positive electrode profile and an adjusted negative electrode profile corresponding to the battery profile among the plurality of adjusted positive electrode profiles and the plurality of adjusted negative electrode profiles, and obtain the selected adjusted negative electrode profile as the negative electrode profile of the target battery.

The diagnostic factor obtaining unit 130 is configured to obtain a diagnostic factor value representing the available capacity per unit area of the negative electrode based on the negative electrode profile.

As will be described further below, the diagnostic factor obtaining unit 130 may be configured to calculate the diagnostic factor value based on a negative electrode shrinkage ratio, which represents the degree of shrinkage of the negative electrode profile compared to a reference negative electrode profile representing the relationship between the negative electrode capacity and the negative electrode potential of the reference battery, and a predetermined reference value for the diagnostic factor.

For example, the diagnostic factor value (n-loading) may be calculated as in Formula 1.

[Formula 1]

$$\text{n-loading} = (\text{ns} \,/\, 100) \times \text{Ln} \; [\text{mAh/cm}^2]$$

In Formula 1, n-loading is a diagnostic factor representing the available capacity per unit area of the negative electrode, ns is the negative electrode shrinkage ratio representing the degree of shrinkage of the negative electrode profile of the target battery compared to the reference negative electrode profile, and Ln represents the reference available capacity per unit area of the negative electrode.

The diagnosing unit 140 is configured to diagnose the state of the negative electrode based on diagnostic factor values sequentially obtained as the charge cycle or the discharge cycle is repeated.

In an embodiment, the diagnosing unit 140 may be configured to diagnose that degradation of the negative electrode is in progress when the diagnostic factor values show a trend of increasing and then decreasing for a predetermined period or longer as the charge cycle or the discharge cycle is repeated.

Additionally, the diagnosing unit 140 may be configured to determine a maximum value among the diagnostic factor values, and to diagnose the state of the negative electrode as an abnormal state if another diagnostic factor value obtained after an acquisition time point of a diagnostic factor value corresponding to the determined maximum value is less than a predetermined first threshold value.

Additionally, the diagnosing unit 140 may be configured to diagnose the state of the target battery as a dangerous state requiring discontinuation of use if another diagnostic factor value obtained after the acquisition time point of the diagnostic factor value corresponding to the maximum value is less than a predetermined second threshold value. In this case, the second threshold value may be determined to be a value less than the first threshold value.

In an embodiment, the apparatus 100 for diagnosing a battery may further include a charge/discharge adjusting unit 150.

In this case, the charge/discharge adjusting unit 150 may be configured to adjust a charging condition and/or a discharging condition of the target battery, such as a voltage at full charge of the target battery and a current rate of the charge current or discharge current of the target battery, according to the diagnosis result of the diagnosing unit 140 described above. For example, when the negative electrode of the target battery is diagnosed as being in an abnormal state, the charge/discharge adjusting unit 150 may control a charging/discharging unit (not shown) that charges and discharges the target battery to lower the voltage at full charge of the target battery or reduce the current rate of the charge/discharge current.

In an embodiment, the apparatus 100 for diagnosing a battery may further include an output unit 160.

In this case, the output unit 160 may be configured to output information about the battery diagnosis result through visual, auditory, or audiovisual means. To this end, the output unit 160 may be linked to a visual display device such as a display, a light-emitting diode, or the like, and an audio device such as a speaker, or may optionally include the visual display device and the audio device. For example, when the state of the negative electrode of the target battery is diagnosed as being an abnormal state or a dangerous state, the output unit 160 may be configured to output the diagnosis result or a predetermined alarm.

The battery profile generating unit 110, the negative electrode profile obtaining unit 120, the diagnostic factor obtaining unit 130, the diagnosing unit 140, the charge/discharge adjusting unit 150, and the output unit 160 of the apparatus 100 for diagnosing a battery described above may be implemented by a combination of a processor and a program executed by the processor. The apparatus 100 for diagnosing a battery may be implemented by a single processor, or by two or more processors that are interconnected.

In an embodiment, the apparatus 100 for diagnosing a battery according to the present disclosure may be configured to interact with various sensors, such as a voltage sensor 12a for sensing the voltage of the target battery, a current sensor 12b for sensing the charge/discharge current of the target battery, etc.

In addition, the apparatus 100 for diagnosing a battery according to the present disclosure may be configured to interwork with a communication unit 14 that performs communication with another device located remotely. In this case, the communication unit 14 may be configured to receive data transmitted from a remote server or communication terminal through a wired/wireless communication network and transmit the data to the apparatus 100 for diagnosing a battery, or transmit data generated in the apparatus 100 for diagnosing a battery to another server or communication terminal. To this end, the communication unit 14 may include a communication modem that performs wired communication and/or wireless communication.

In addition, the apparatus 100 for diagnosing a battery according to the present disclosure may be configured to be linked with a storage unit 16 capable of storing a program or data necessary for battery diagnosis. In this case, the storage unit 16 may include one or more of various types of recording media such as RAM, ROM, EEPROM, flash memory, registers, etc.

In another embodiment, the apparatus 100 for diagnosing a battery according to the present disclosure may be configured to include one or more of the voltage sensor 12a, the current sensor 12b, the communication unit 14, and the storage unit 16 described above.

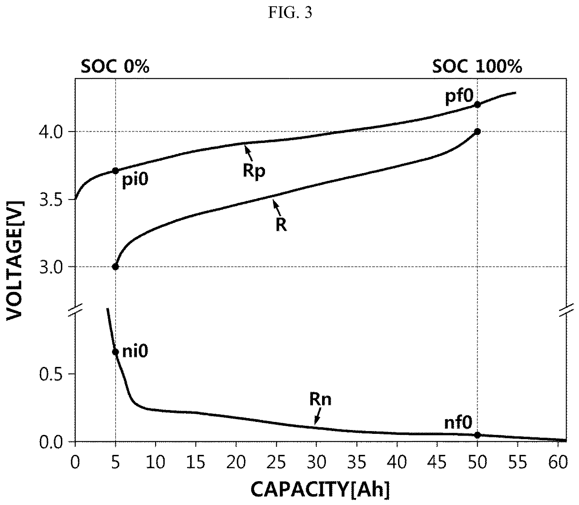

FIGS. 3 to 10 are drawings showing a process for obtaining a negative electrode profile of a target battery according to an embodiment of the present disclosure.

First, FIG. 3 shows a reference positive electrode profile Rp and a reference negative electrode profile Rn corresponding to a predetermined reference battery profile R. In FIG. 3, the horizontal axis represents capacity and the vertical axis represents voltage.

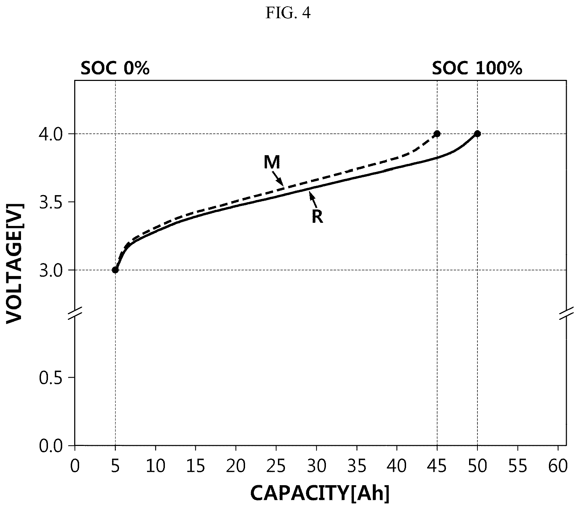

FIG. 4 illustrates the battery profile M of the target battery. In FIG. 4, the horizontal axis represents capacity and the vertical axis represents voltage.

The negative electrode profile obtaining unit 120 may be configured to compare the battery profile M and at least one combination profile. Here, the combination profile may be the result of combining the adjusted positive electrode profile and the adjusted negative electrode profile based on the reference positive electrode profile Rp and the reference negative electrode profile Rn, respectively, stored in the storage unit 16.

In other words, when the reference battery profile R is the result of subtracting a part of the reference negative electrode profile Rn from a part of the reference positive electrode profile Rp, the combination profile may be said to be the result of subtracting a part of the adjusted negative electrode profile from a part of the adjusted positive electrode profile.

The negative electrode profile obtaining unit 120 may generate at least one combination profile by directly adjusting the reference positive electrode profile Rp and the reference negative electrode profile Rn. Alternatively, at least one combination profile may be secured in advance based on the reference positive electrode profile Rp and the reference negative electrode profile Rn and stored in the storage unit 16. In this case, the negative electrode profile obtaining unit 120 may obtain the combination profile from the storage unit 16.

The negative electrode profile obtaining unit 120 may generate a plurality of combination profiles from the reference positive electrode profile Rp and the reference negative electrode profile Rn by repeating the process of adjusting each of the reference positive electrode profile Rp and the reference negative electrode profile Rn to various levels and then combining them. The combination profile may also be called an 'adjusted reference battery profile'.

The negative electrode profile obtaining unit 120 may select a combination profile that has a minimum error with the battery profile M among the plurality of combination profiles.

Next, the negative electrode profile obtaining unit 120 may determine the adjusted positive electrode profile and the adjusted negative electrode profile corresponding to the selected combination profile as the positive electrode profile and the negative electrode profile representing the current state of the target battery. In the following, it should be noted that the positive electrode profile is a finally determined adjusted positive electrode profile, and the negative electrode profile is a finally determined adjusted positive electrode profile.

In relation to this, various methods known at the filing time of the present disclosure may be employed to determine the error between two profiles, each of which may be expressed in a two-dimensional coordinate system. For example, the integral value of the absolute value of the area between two profiles or RMSE (Root Mean Square Error) may be used as the error between two profiles.

According to this configuration of the present disclosure, various state information about the battery may be obtained based on the finally determined positive electrode profile and negative electrode profile. The finally determined positive electrode profile and negative electrode profile correspond to the combination profile most similar to the battery profile. In other words, it may be said that the combination profile generated by combining the finally determined positive electrode profile and negative electrode profile is almost identical to the battery profile M in terms of shape.

Therefore, according to the present disclosure, the positive electrode profile and the negative electrode profile of the target battery may be obtained even without disassembling the target battery.

If the target battery is a new battery, the positive electrode profile and the negative electrode profile of the target battery may be analyzed to more easily diagnose whether a defect has occurred in the target battery and, if so, what type of defect it is.

In addition, if the target battery is already being used, it is possible to determine the extent to which the target battery has deteriorated for each deterioration item through the positive electrode profile and the negative electrode profile of the battery.

Furthermore, according to the present disclosure, the positive electrode profile and the negative electrode profile of the battery may be obtained through a simple process. Even if only one reference positive electrode profile Rp and one reference negative electrode profile Rn are stored in the storage unit 16, the present disclosure may be implemented. That is, there is no need to store a plurality of reference positive electrode profiles Rp and/or a plurality of reference negative electrode profiles Rn in the storage unit 16. Accordingly, the storage capacity of the storage unit 16 does not need to be high, and there is no need to conduct numerous preliminary tests required to secure a plurality of reference positive electrode profiles Rp and/or a plurality of reference negative electrode profiles Rn.

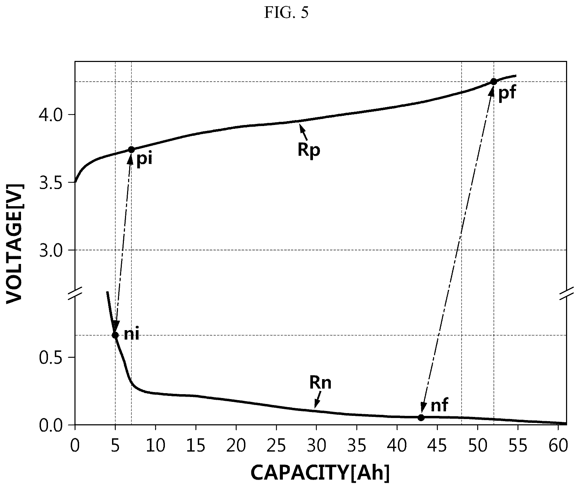

FIGS. 5 to 7 are diagrams referenced to for explaining an example of a procedure for generating a combination profile used for comparison with the battery profile M according to an embodiment of the present disclosure.

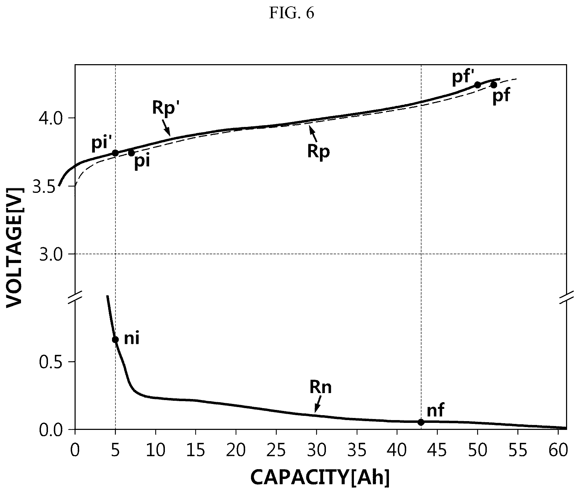

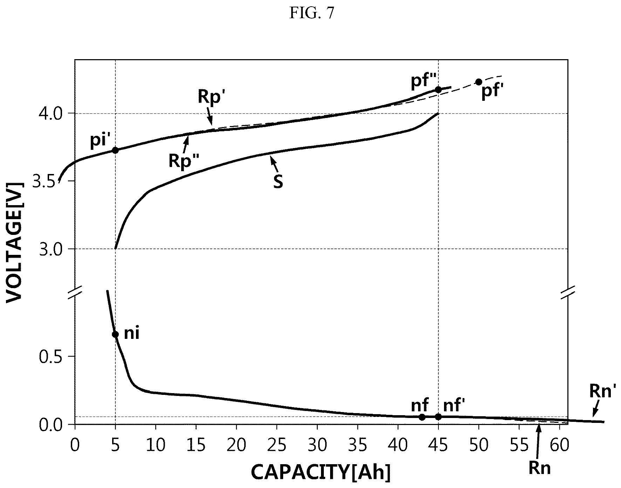

The procedure for generating a combination profile, which will be described with reference to FIGS. 5 to 7, proceeds in the following order: a first process that sets four points (positive electrode participation initiating point, positive electrode participation finalizing point, negative electrode participation initiating point, negative electrode participation finalizing point) to correspond to the voltage range of interest (see FIG. 5), a second process that performs profile shifting (see FIG. 6), and a third process that performs capacity scaling (see FIG. 7). That is, the procedure for generating a combination profile according to an embodiment of the present disclosure includes the first to third processes.

First, referring to FIG. 5, the reference positive electrode profile Rp and the reference negative electrode profile Rn are the same as those shown in FIG. 3.

The negative electrode profile obtaining unit 120 determines a positive electrode participation initiating point pi, a positive electrode participation finalizing point pf, a negative electrode participation initiating point ni, and a negative electrode participation finalizing point nf on the reference positive electrode profile Rp and the reference negative electrode profile Rn.

Either the positive electrode participation initiating point pi or the negative electrode participation initiating point ni depends on the other.

As an example, the negative electrode profile obtaining unit 120 divides the positive electrode voltage range from the starting point of the reference positive electrode profile Rp to the end point (or second setting voltage) into a plurality of micro voltage sections, and then set the boundary point of two adjacent micro voltage sections among the plurality of micro voltage sections as the positive electrode participation initiating point pi. Each micro voltage section may have a predetermined size (e.g., 0.01 V). Next, the negative electrode profile obtaining unit 120 may set a point on the reference negative electrode profile Rn, which is smaller than the positive electrode participation initiating point pi by the first setting voltage (e.g., 3 V), as the negative electrode participation initiating point ni.

As another example, the negative electrode profile obtaining unit 120 may divide the negative electrode voltage range from the start point to the end point of the reference negative electrode profile Rn into a plurality of micro voltage sections of a predetermined size, and then set the boundary point of two adjacent micro voltage sections among the plurality of micro voltage sections as the negative electrode participation initiating point ni. Next, the negative electrode profile obtaining unit 120 may search for a point, which is greater than the negative electrode participation initiating point ni by the first setting voltage, from the reference positive electrode profile Rp and set the searched point as the positive electrode participation initiating point pi.

Also, either the positive electrode participation finalizing point pf and the negative electrode participation finalizing point nf depends on the other.

As an example, the negative electrode profile obtaining unit 120 may divide the voltage range from the second setting voltage to the end point of the reference positive electrode profile Rp into a plurality of micro voltage sections of a predetermined size, and then set the boundary point of two adjacent micro voltage sections among the plurality of micro voltage sections as the positive electrode participation finalizing point pf. Next, the negative electrode profile obtaining unit 120 may set a point on the reference negative electrode profile Rn, which is smaller than the positive electrode participation finalizing point pf by a second setting voltage (e.g., 4 V), as the negative electrode participation finalizing point nf.

As another example, the negative electrode profile obtaining unit 120 may divide the negative electrode voltage range from the start point to the end point of the reference negative electrode profile Rn into a plurality of micro voltage sections of a predetermined size, and then set the boundary point of two adjacent micro voltage sections among the plurality of micro voltage sections as the negative electrode participation finalizing point nf. Next, the negative electrode profile obtaining unit 120 may search for a point, which is greater than the negative electrode participation finalizing point nf by a second setting voltage, from the reference positive electrode profile Rp and set the searched point as the positive electrode participation finalizing point pf.

If the determination of the positive electrode participation initiating point pi, the positive electrode participation finalizing point pf, the negative electrode participation initiating point ni, and the negative electrode participation finalizing point nf is completed as above, the negative electrode profile obtaining unit 120 shifts at least one of the reference positive electrode profile Rp and the reference negative electrode profile Rn to the left or right along the horizontal axis (capacity axis).

Referring to FIG. 6, the negative electrode profile obtaining unit 120 may shift the reference positive electrode profile Rp and/or the reference negative electrode profile Rn so that the capacity values of the positive electrode participation initiating point pi and the negative electrode participation initiating point ni match.

Alternatively, the negative electrode profile obtaining unit 120 may shift the reference positive electrode profile Rp and/or the reference negative electrode profile Rn so that the capacity values of the positive electrode participation finalizing point pf and the negative electrode participation finalizing point nf match.

FIG. 6 shows the situation that the adjusted reference positive electrode profile Rp' is generated by shifting the reference positive electrode profile Rp to the left, and as a result, the capacity values of the positive electrode participation initiating point pi' matches the voltage of the negative electrode participation initiating point ni. The adjusted reference positive electrode profile Rp' is the result of applying an adjustment procedure of shifting to the left by the capacity value difference between the positive electrode participation initiating point pi and the negative electrode participation initiating point ni to the reference positive electrode profile Rp. Therefore, the two points pi, pi' differ only in capacity value and have the same voltage. The two points pf, pf' differ only in capacity value and have the same voltage.

When the adjustment result profiles Rp', Rn in which at least one of the reference positive electrode profile Rp and the reference negative electrode profile Rn is shifted are secured, the negative electrode profile obtaining unit 120 scales the capacity range of at least one of the adjustment result profiles Rp', Rn.

According to the example shown in FIG. 6, the negative electrode profile obtaining unit 120 performs an additional adjustment procedure to shrink or expand at least one of the adjusted reference positive electrode profile Rp' and the adjusted reference negative electrode profile Rn along the horizontal axis (capacity axis).

Referring to FIG. 7, the negative electrode profile obtaining unit 120 may generate an adjusted reference positive electrode profile Rp" by shrinking or expanding the adjusted reference positive electrode profile Rp' so that the size of the capacity range between the two points pi', pf' of the adjusted reference positive electrode profile Rp' matches the size of the capacity range of the battery profile M. At this time, any one of the two points pi', pf' may be fixed. Accordingly, the capacity difference between the two points pi', pf" of the adjusted reference positive electrode profile Rp" may be matched to the size of the capacity range of the battery profile M.

In addition, the negative electrode profile obtaining unit 120 may generate an adjusted reference negative electrode profile Rn' by shrinking or expanding the reference negative electrode profile Rn so that the size of the capacity range between two points ni, nf of the reference negative electrode profile Rn matches the size of the capacity range of the battery profile M. At this time, any one of the two points ni, nf may be fixed. Accordingly, the capacity difference between the two points ni, nf' of the adjusted reference negative electrode profile Rn' may be matched to the capacity range of the battery profile M.

In FIG. 7, the adjusted reference positive electrode profile Rp" is the result of shrinkage of the adjusted reference positive electrode profile Rp' shown in FIG. 6, and the adjusted reference negative electrode profile Rn' is the result of expansion of the reference negative electrode profile Rn shown in FIG. 6.

The positive electrode participation finalizing point pf" on the adjusted reference positive electrode profile Rp" corresponds to the positive electrode participation finalizing point pf' on the adjusted reference positive electrode profile Rp'. The negative electrode participation finalizing point nf' on the adjusted reference negative electrode profile Rn' corresponds to the negative electrode participation finalizing point nf on the reference negative electrode profile Rn.

The capacity difference between the positive electrode participation initiating point pi' and the positive electrode participation finalizing point pf'' of the adjusted reference positive electrode profile Rp" corresponds to the size of the capacity range of the battery profile M. Likewise, the capacity difference between the negative electrode participation initiating point ni and the negative electrode participation finalizing point nf' of the adjusted reference negative electrode profile Rn' corresponds to the size of the capacity range of the battery profile M.

In addition, the capacity difference between two points pi', pf" of the adjusted reference positive electrode profile Rp" matches the capacity difference between two points ni, nf' of the adjusted reference negative electrode profile Rn'. The negative electrode profile obtaining unit 120 may generate the combination profile S by subtracting the portion between two points ni, nf' of the adjusted reference negative electrode profile Rn' from the portion between two points pi', pf" of the adjusted reference positive electrode profile Rp".

The negative electrode profile obtaining unit 120 may calculate the error (profile error) between the combination profile S and the battery profile M. When the error between the combination profile S and the battery profile M is minimized, the adjusted reference positive electrode profile Rp" corresponding to the combination profile S may be determined as the adjusted positive electrode profile, and the adjusted reference negative electrode profile Rn' may be determined as the adjusted negative electrode profile.

The negative electrode profile obtaining unit 120 may map at least two of the adjusted reference positive electrode profile Rp", the adjusted reference negative electrode profile Rn', the positive electrode participation initiating point pi', the positive electrode participation finalizing point pf", the negative electrode participation initiating point ni, the negative electrode participation finalizing point nf', the first scale factor, the second scale factor, the combination profile S, and the profile error to each other and record in the storage unit 16. Here, the first scale factor may represent the rate of the capacity difference between two points pi', pf" relative to the capacity difference between two points pi0, pf0. The second scale factor may represent the rate of the capacity difference between two points ni, nf' relative to the capacity difference between two points ni0, nf0.

In addition, the negative electrode profile obtaining unit 120 may calculate the positive electrode shrinkage ratio ps of the adjusted reference positive electrode profile Rp" for the reference positive electrode profile Rp. Also, the negative electrode profile obtaining unit 120 may calculate the negative electrode shrinkage ratio ns of the adjusted reference negative electrode profile Rn' for the reference negative electrode profile Rn. In this case, the negative electrode profile obtaining unit 120 may determine the first scale factor as the positive electrode shrinkage ratio ps and determine the second scale factor as the negative electrode shrinkage ratio ns.

Meanwhile, as described above, when the positive electrode voltage range of the reference positive electrode profile Rp is divided into a plurality of micro voltage sections, the boundary point of two adjacent micro voltage sections among the plurality of micro voltage sections may be set as the positive electrode participation initiating point pi.

For example, if the positive electrode voltage range of the reference positive electrode profile Rp is divided into 100 small voltage ranges, there may be 100 boundary points that may be set as the positive electrode participation initiating point pi. In addition, if the voltage range equal to or greater than the second setting voltage in the reference positive electrode profile Rp is divided into 40 small voltage ranges, there may be 40 boundary points that may be set as the positive electrode participation finalizing point pf. In this case, up to 4000 different combination profiles may be generated.

Of course, it will be easy to understand by those skilled in the art that as the size of the micro voltage section decreases, the number of combination profiles that may be maximally generated increases, and conversely, as the size of the micro voltage section increases, the number of combination profiles that may be maximally generated decreases.

The negative electrode profile obtaining unit 120 may identify the minimum value among the profile errors of the plurality of combination profile generated as described above, and then obtain information (e.g., at least one of the positive electrode participation initiating point pi, the positive electrode participation finalizing point pf, the negative electrode participation initiating point ni, the negative electrode participation finalizing point nf, the positive electrode shrinkage ratio ps, the negative electrode shrinkage ratio ns, and the capacity ratio between the positive electrode and the negative electrode) mapped to the minimum profile error from the storage unit 16.

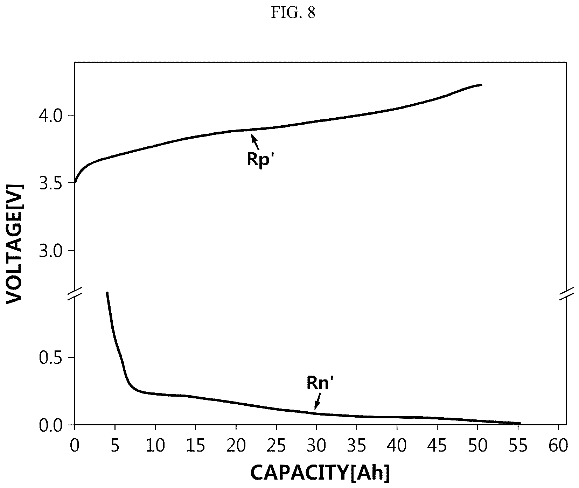

FIGS. 8 to 10 are diagrams referenced to for explaining another embodiment of a procedure for generating a combination profile used for comparison with the battery profile M according to an embodiment of the present disclosure.

For reference, the embodiments shown in FIGS. 8 to 10 are independent from the embodiments shown in FIGS. 5 to 7. Accordingly, terms or symbols commonly used in describing the embodiments shown in FIGS. 5 to 7 and the embodiments shown in FIGS. 8 to 10 should be understood as being limited to each embodiment.

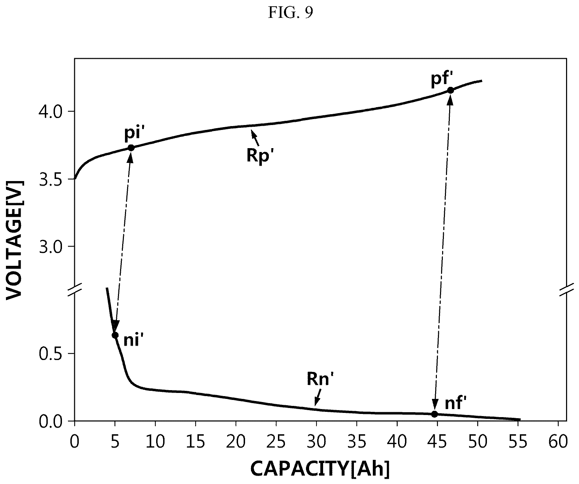

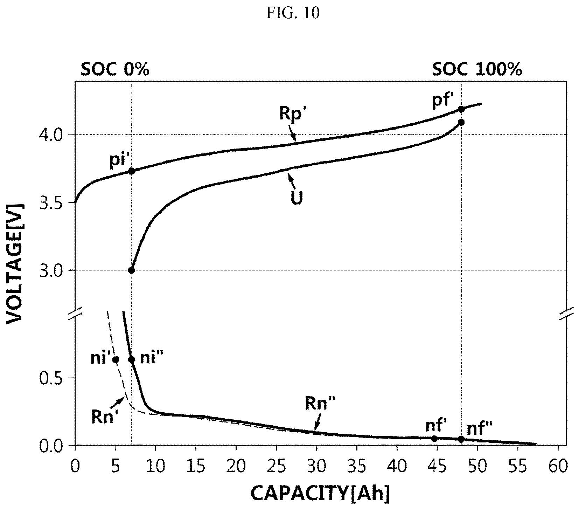

The generation procedure of the combination profile to be explained with reference to FIGS. 8 to 10 proceeds in the following order: a fourth process for performing capacity scaling (see FIG. 8), a fifth process of setting four points (the positive electrode participation initiating point, the positive electrode participation finalizing point, the negative electrode participation initiating point and the negative electrode participation finalizing point (see FIG. 9), and a sixth process of performing profile shift (see FIG. 10). That is, the generation procedure of the combination profile according to another embodiment of the present disclosure includes the fourth to sixth processes.

First, the reference positive electrode profile Rp and the reference negative electrode profile Rn are the same as those shown in FIG. 3.

The negative electrode profile obtaining unit 120 generates an adjusted reference positive electrode profile Rp' and an adjusted reference negative electrode profile Rn' by applying the first scale factor and the second scale factor selected from the scaling value range to the reference positive electrode profile Rp and the reference negative electrode profile Rn, respectively.

The scaling value range may be predetermined or may vary depending on the rate of the size of the capacity range of the battery profile M relative to the size of the capacity range of the reference battery profile R. As an example, assuming that the first scale factor and the second scale factor may be selected among the values spaced by 0.1% (i.e., 90%, 90.1%, 90.2%, ..., 98.9%, 99%) in the scaling numerical range (e.g., 90 to 99%), 91 values may be selected as the first scale factor and the second scale factor, respectively. In this case, up to 8,281 adjusted profile pairs may be generated to 91 × 91 = 8,281 adjustment levels (combination of first scale factor and second scale factor). The adjusted profile pair refers to a combination of the adjusted reference positive electrode profile and the adjusted reference negative electrode profile.

FIG. 8 shows an example in which the adjusted reference positive electrode profile Rp' and the adjusted reference negative electrode profile Rn' are the results of applying a first scale factor and a second scale factor less than 100% to the reference positive electrode profile Rp and the reference negative electrode profile Rn, respectively.

Since the first scale factor and the second scale factor are less than 100%, the adjusted reference positive electrode profile Rp' is the shrinkage of the reference positive electrode profile Rp along the horizontal axis, and the adjusted reference negative electrode profile Rn' is also the shrinkage of the reference negative electrode profile Rn along the horizontal axis. To facilitate understanding, the example is illustrated in the form where the starting point of each of the positive electrode profile Rp and the reference negative electrode profile Rn is fixed and the remaining portions are reduced to the left along the horizontal axis.

Referring to FIG. 9, the negative electrode profile obtaining unit 120 determines the positive electrode participation initiating point pi', the positive electrode participation finalizing point pf', the negative electrode participation initiating point ni' and the negative electrode participation finalizing point nf' on the adjusted reference positive electrode profile Rp' and the adjusted reference negative electrode profile Rn'.

Either the positive electrode participation initiating point pi' or the negative electrode participation initiating point ni' may depend on the other. Additionally, either the positive electrode participation finalizing point pf' or the negative electrode participation finalizing point nf' may depend on the other. Additionally, either the positive electrode participation initiating point pi' or the positive electrode participation finalizing point pf' may be set based on the other.

That is, if any one of the positive electrode participation initiating point pi', the positive electrode participation finalizing point pf', the negative electrode participation initiating point ni', and the negative electrode participation finalizing point nf' is set, the remaining three points may be set automatically by the first setting voltage, the second setting voltage and/or the size of the capacity range of the battery profile M (e.g., charging capacity of SOC 0% to 100%).

As an example, the negative electrode profile obtaining unit 120 may divide the positive electrode voltage range from the start point of the adjusted reference positive electrode profile Rp' to the end point (or second setting voltage) into a plurality of micro voltage section, and then set the boundary point of two adjacent micro voltage sections among the plurality of micro voltage sections as the positive electrode participation initiating point pi'. Next, the negative electrode profile obtaining unit 120 may set the point on the adjusted reference negative electrode profile Rn, which is smaller than the positive electrode participation initiating point pi' by the first setting voltage (e.g., 3 V), as the negative electrode participation initiating point ni'.

As another example, the negative electrode profile obtaining unit 120 may divide the negative electrode voltage range from the start point to the end point of the adjusted reference negative electrode profile Rn' into a plurality of micro voltage sections of a predetermined size, and then set the boundary point of two adjacent voltage sections among the plurality of micro voltage sections as the negative electrode participation initiating point ni'. Next, the negative electrode profile obtaining unit 120 may search for a point, which is greater than the negative electrode participation initiating point ni' by the first setting voltage, from the reference positive electrode profile Rp and set the searched point as the positive electrode participation initiating point pi'.

As another example, the negative electrode profile obtaining unit 120 may divide the voltage range from the second setting voltage to the end point of the adjusted reference positive electrode profile Rp' into a plurality of micro voltage sections of a predetermined size, and then set the boundary point of the two micro voltage sections among the plurality of micro voltage sections as the positive electrode participation finalizing point pf'. Next, the negative electrode profile obtaining unit 120 may search for a point, which is smaller than the positive electrode participation finalizing point pf' by the second setting voltage (e.g., 4 V), in the adjusted reference negative electrode profile Rn', and set the searched point as the negative electrode participation finalizing point nf'.

As another example, the negative electrode profile obtaining unit 120 may divide the negative electrode voltage range from the start point to the end point of the adjusted reference negative electrode profile Rn' into a plurality of micro voltage sections of a predetermined size, and then set the boundary point of two adjacent micro voltage sections among the plurality of micro voltage sections as the negative electrode participation finalizing point nf'. Next, the negative electrode profile obtaining unit 120 may search for a point, which is greater than the negative electrode participation finalizing point nf' by the second setting voltage, from the adjusted reference positive electrode profile Rp' and set the searched point as the positive electrode participation finalizing point pf'.

If any one of the positive electrode participation initiating point pi', the positive electrode participation finalizing point pf', the negative electrode participation initiating point ni', and the negative electrode participation finalizing point nf' is determined, the negative electrode profile obtaining unit 120 may additionally determine the remaining points based on the determined point.

As an example, if the positive electrode participation initiating point pi' is determined first, the negative electrode profile obtaining unit 120 may set the point on the adjusted reference positive electrode profile Rp', which has a capacity value that is larger than the capacity value of the positive electrode participation initiating point pi' by the size of the capacity range of the battery profile M, as the positive electrode participation finalizing point pf'. Additionally, the negative electrode profile obtaining unit 120 may search for a point, which is lower than the positive electrode participation initiating point pi' by the first setting voltage, from the adjusted reference negative electrode profile Rn' and set the searched point as the negative electrode participation initiating point ni'. In addition, the negative electrode profile obtaining unit 120 may set a point on the adjusted reference negative electrode profile Rn', which has a capacity value larger than the capacity value of the negative electrode participation initiating point ni' by the size of the capacity range of the battery profile M, as the negative electrode participation finalizing point nf'.

As another example, if the positive electrode participation finalizing point pf' is determined first, the negative electrode profile obtaining unit 120 may set a point on the adjusted reference positive electrode profile Rp', which has a capacity value smaller than the capacity value of the positive electrode participation finalizing point pf' by the size of the capacity range of the battery profile M, as the positive electrode participation initiating point pi'. Additionally, the negative electrode profile obtaining unit 120 may search for a point, which is lower than the positive electrode participation finalizing point pf' by the second setting voltage, from the adjusted reference negative electrode profile Rn' and set the searched point as the negative electrode participation finalizing point nf'. In addition, the negative electrode profile obtaining unit 120 may set a point on the adjusted reference negative electrode profile Rn', which has a capacity value smaller than the capacity value of the negative electrode participation finalizing point nf' by the size of the capacity range of the battery profile M, as the negative electrode participation initiating point ni'.

As still another example, if the negative electrode participation initiating point ni' is determined, the negative electrode profile obtaining unit 120 may set a point on the reference negative electrode profile Rn', which has a capacity value larger than the capacity value of the negative electrode participation initiating point ni' by the size of the capacity range of the battery profile M, set as the negative electrode participation finalizing point nf'. Additionally, the negative electrode profile obtaining unit 120 may search for a point, which is higher than the negative electrode participation initiating point ni' by the first setting voltage, from the adjusted reference positive electrode profile Rp' and set the searched point as the positive electrode participation initiating point pi'. In addition, the negative electrode profile obtaining unit 120 may set a point on the adjusted reference positive electrode profile Rp', which has a capacity value greater than the capacity value of the positive electrode participation initiating point pi' by the size of the capacity range of the battery profile M, as the positive electrode participation finalizing point pf'.

As still another example, if the negative electrode participation finalizing point nf' is determined, the negative electrode profile obtaining unit 120 may set a point on the reference negative electrode profile Rn', which has a capacity value smaller than the capacity value of the negative electrode participation finalizing point nf' by the size of the capacity range of the battery profile M, as the negative electrode participation initiating point ni'. Additionally, the negative electrode profile obtaining unit 120 may search for a point, which is higher than the negative electrode participation finalizing point nf' by the second setting voltage, from the adjusted reference positive electrode profile Rp' and set the searched point as the positive electrode participation finalizing point pf'. In addition, the negative electrode profile obtaining unit 120 may set a point on the adjusted reference positive electrode profile Rp', which has a capacity value smaller than the capacity value of the positive electrode participation finalizing point pf' by the size of the capacity range of the battery profile M, as the positive electrode participation initiating point pi'.

If the determination of the positive electrode participation initiating point pi', the positive electrode participation finalizing point pf', the negative electrode participation initiating point ni' and the negative electrode participation finalizing point nf' is completed based on the pair of first scale factor and second scale factor, the negative electrode profile obtaining unit 120 may shift at least one of the adjusted reference positive electrode profile Rp' and the adjusted reference negative electrode profile Rn' along the horizontal axis so that the capacity values of the positive electrode participation initiating point pi' and the negative electrode participation initiating point ni' match or the capacity values of the positive electrode participation finalizing point pf' and the negative electrode participation finalizing point nf' match.

The adjusted reference negative electrode profile Rn" shown in FIG. 10 is obtained by shifting only the adjusted reference negative electrode profile Rn' shown in FIG. 9 to the right. Accordingly, the capacity values of the positive electrode participation initiating point pi' and the negative electrode participation initiating point ni" match each other. In this regard, since the capacity difference between the positive electrode participation initiating point pi' and the positive electrode participation finalizing point pf' is the same as the capacity difference between the negative electrode participation initiating point ni' and the negative electrode participation finalizing point nf', if the capacity values of the positive electrode participation initiating point pi' and the negative electrode participation initiating point ni" match each other, the capacity values of the positive electrode participation finalizing point pf' and the negative electrode participation finalizing point nf" also match each other.

Referring to FIG. 10, the negative electrode profile obtaining unit 120 may generate the combination profile U by subtracting a partial profile between two points pi', pf' of the adjusted reference positive electrode profile Rp' from the partial profile between into two points ni", nf" of the adjusted reference negative electrode profile Rn".

The negative electrode profile obtaining unit 120 may calculate the error (profile error) between the combination profile U and the battery profile M. When the error between the combination profile U and the battery profile M is minimized, the adjusted reference positive electrode profile Rp' corresponding to the combination profile U may be determined as the adjusted positive electrode profile, and the adjusted reference negative electrode profile Rn" may be determined as the adjusted negative electrode profile.

The negative electrode profile obtaining unit 120 may map at least two of the adjusted reference positive electrode profile Rp', the adjusted reference negative electrode profile Rn", the positive electrode participation initiating point pi', the positive electrode participation finalizing point pf', the negative electrode participation initiating point ni", the negative electrode participation finalizing point nf", the positive electrode shrinkage ratio ps, the negative electrode shrinkage ratio ns, the combination profile U, and the profile error with each other and record in the storage unit 16.

Here, the negative electrode profile obtaining unit 120 may calculate the positive electrode shrinkage ratio ps of the adjusted reference positive electrode profile Rp' for the reference positive electrode profile Rp. Also, the negative electrode profile obtaining unit 120 may calculate the negative electrode shrinkage ratio ns of the adjusted reference negative electrode profile Rn" for the reference negative electrode profile Rn. For example, the negative electrode profile obtaining unit 120 may determine the first scale factor as the positive electrode shrinkage ratio ps and determine the second scale factor as the negative electrode shrinkage ratio ns.

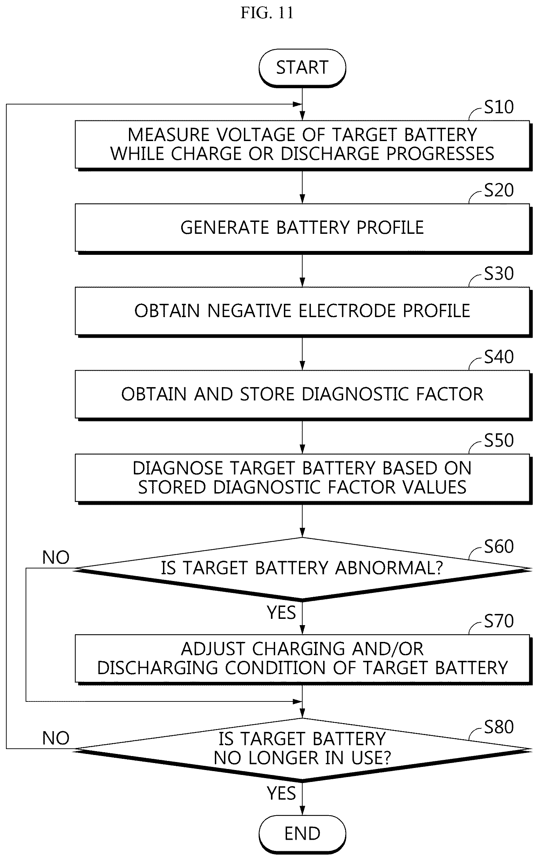

FIG. 11 is a flow chart showing a method for diagnosing a battery according to an embodiment of the present disclosure.

As illustrated in FIG. 11, the method for diagnosing a battery according to the present disclosure is a method for diagnosing a target battery having a negative electrode to which an active material that undergoes phase transformation as charge and discharge proceeds is applied, in a non-destructive manner, and may be performed by a processor.

First, the processor measures voltage values according to the capacity of the target battery using the voltage sensor 12a while a predetermined number of charge cycles or discharge cycles are in progress (S10).

Also, the processor generates the battery profile based on the measured voltage values (S20). For reference, the current capacity of the target battery may be calculated by applying the current integration method to the charge current or discharge current of the target battery. For this purpose, the processor may be linked with the current sensor 12b that senses the charge current or discharge current of the target battery.

Next, the processor obtains a negative electrode profile that estimates the relationship between the negative electrode capacity and negative electrode potential of the target battery based on the battery profile (S30).

In this case, the processor may generate a plurality of adjusted positive electrode profiles differently adjusted and a plurality of adjusted negative electrode profiles differently adjusted by adjusting a reference positive electrode profile representing a relationship between a positive electrode capacity and a positive electrode potential of a predetermined reference battery and a reference negative electrode profile representing a relationship between a negative electrode capacity and a negative electrode potential of the reference battery, respectively. For reference, the reference battery may be a target battery at the BOL (Beginning of Life) time point or a battery in a normal state with the same configuration as the target battery.

Also, the processor may select an adjusted positive electrode profile and an adjusted negative electrode profile corresponding to the battery profile among the plurality of adjusted positive electrode profiles and the plurality of adjusted negative electrode profiles, and obtain the selected adjusted negative electrode profile as the negative electrode profile of the target battery.

Next, the processor obtains and stores a diagnostic factor value representing the available capacity per unit area of the negative electrode based on the negative electrode profile (S40).

In this case, the processor may be configured to calculate the diagnostic factor value based on a negative electrode shrinkage ratio, which represents a degree of shrinkage of the negative electrode profile compared to a reference negative electrode profile representing a relationship between the negative electrode capacity and the negative electrode potential of the reference battery, and a predetermined reference value regarding the diagnostic factor. For example, the processor may calculate the diagnostic factor value by applying the Formula 1 described above.

Next, the processor diagnoses the state of the negative electrode based on diagnostic factor values sequentially obtained as the charge cycle or the discharge cycle is repeated (S50).

In an embodiment, the processor may diagnose that degradation of the negative electrode is in progress when the diagnostic factor values show a trend of increasing and then decreasing for a predetermined period or longer as the charge cycle or the discharge cycle is repeated.

In addition, the processor may be configured to determine a maximum value among the diagnostic factor values, and to diagnose the state of the negative electrode as an abnormal state if another diagnostic factor value obtained after the acquisition time point of the diagnostic factor value corresponding to the determined maximum value is less than a predetermined first threshold value (S60).

Additionally, the processor may be configured to diagnose the state of the target battery as a dangerous state requiring discontinuation of use if another diagnostic factor value obtained after the acquisition time point of the diagnostic factor value corresponding to the maximum value is less than a predetermined second threshold value. In this case, the second threshold value may be determined to be a value less than the first threshold value.

Then, the processor adjusts the charging condition and/or the discharging condition of the target battery, such as the voltage at full charge of the target battery and the current rate of the charge current or discharge current of the target battery, according to the diagnosis result of the target battery (S70). For example, if the negative electrode of the target battery is diagnosed as being in an abnormal state, the processor may control a charging/discharging unit (not shown) that charges and discharges the target battery to lower the voltage at full charge of the target battery or reduce the current rate of the charge/discharge current.

In an embodiment, the processor may output information about the battery diagnosis result of the target battery through visual, auditory, or audiovisual means. To this end, the processor may be linked to a visual display device such as a display, a light-emitting diode, or the like, and an audio device such as a speaker. For example, when the state of the negative electrode of the target battery is diagnosed as being an abnormal state or a dangerous state, the processor may output the diagnosis result or a predetermined alarm.

The processor may repeat the above-described steps (S10 to S70) until the target battery is no longer in use (S80).

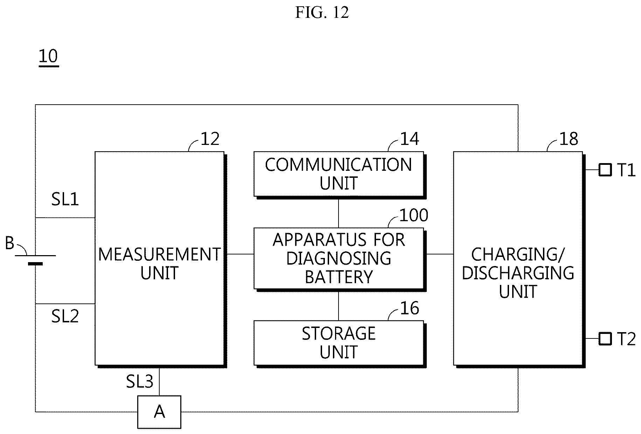

FIG. 12 is a drawing showing a battery pack 10 according to an embodiment of the present disclosure.

As illustrated in FIG. 12, the battery pack 10 includes a battery B allowing charging and discharging and the apparatus 100 for diagnosing a battery according to the present disclosure. In an embodiment, the battery pack 10 may optionally further include a measurement unit 12, a communication unit 14, a storage unit 16, and a charging/discharging unit 18.

The measurement unit 12 may be configured to measure the voltage and/or current of the battery B. To this end, the measurement unit 12 may include a voltage sensor 12a and a current sensor 12b as described with respect to FIG. 1.

The measurement unit 12 may measure the voltage of the battery B through the first sensing line SL1 and the second sensing line SL2. In addition, the measurement unit 12 may measure the current of the battery B through the third sensing line SL3 connected to the current measurement circuit A. The current measurement circuit A may include a shunt resistor.

The apparatus 100 for diagnosing a battery according to an embodiment of the present disclosure may obtain voltage values of the battery B through the measurement unit 12.

The communication device 14 may be configured to perform communication with another device located remotely. For example, the communication device 14 may be configured to receive data transmitted from a remote server or communication terminal through a wired and/or wireless communication network and transmit the data to the apparatus 100 for diagnosing a battery, or transmit data generated in the apparatus 100 for diagnosing a battery to another server or communication terminal. To this end, the communication device 14 may include a communication modem that performs wired communication and/or wireless communication.

The storage unit 16 may be configured to store programs or data required for battery diagnosis. In this case, the storage unit 16 may include one or more of various types of storage media such as RAM, ROM, EEPROM, flash memory, registers, etc.

The charging/discharging unit 18 may be configured to charge and/or discharge the battery B. To this end, the charging/discharging unit 18 may include a charger for charging the battery bank BB, a discharger for discharging the battery B, at least one switch for electrically connecting the battery B to terminals T1, T2 of the battery pack 10, etc.

The apparatus 100 for diagnosing a battery according to an embodiment of the present disclosure may control the charging/discharging unit 18 to perform or stop charging or discharging of the battery bank BB, set charging/discharging conditions, or change the set charging/discharging conditions.

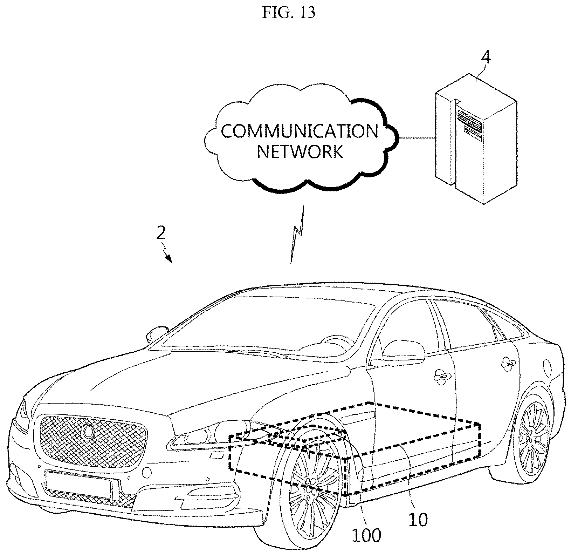

FIG. 13 is a drawing showing a vehicle 2 according to an embodiment of the present disclosure.

As illustrated in FIG. 13, the vehicle 2 according to an embodiment of the present disclosure may include a battery pack 10 that provides electrical energy necessary for the operation of the vehicle and the apparatus 100 for diagnosing a battery according to the present disclosure.

In this case, the apparatus 100 for diagnosing a battery may be configured to interact with an ECU (Electronic Control Unit) that controls the operation of the vehicle 2 or a BMS (Battery Management System) of the battery pack 10.

Additionally, the apparatus 100 for diagnosing a battery may be configured to receive data transmitted from a remote server 4 via a wired and/or wireless communication network, or to transmit data generated by the apparatus 100 for diagnosing a battery to the server 4.

For reference, the apparatus 100 for diagnosing a battery according to the present disclosure may be applied to various electrical devices or electrical systems other than vehicles, as well as to ESS (Energy Storage System).

As described above, according to the present disclosure, the apparatus for diagnosing a battery is configured to generate a battery profile representing a relationship between the capacity and voltage of the target battery for each predetermined number of charge cycles or discharge cycles, obtain a negative electrode profile estimating a relationship between the negative electrode capacity and negative electrode potential of the target battery based on the generated battery profile, and diagnose the state of the negative electrode of the target battery based on diagnostic factor values obtained from the negative electrode profile. Accordingly, even when an active material that undergoes phase transformation, such as pure silicon, is applied to the negative electrode of the target battery, the state of the negative electrode may be diagnosed separately from the state of the positive electrode of the target battery.

In addition, the apparatus for diagnosing a battery is configured to accurately diagnose the degree of activation or degradation of the negative electrode of the target battery and adjust the charge and/or discharging condition of the target battery according to the diagnosis result, thereby delaying the degradation of the negative electrode of the target battery and extending its lifespan.

Furthermore, the embodiments according to the present disclosure may solve various technical problems other than those mentioned in this specification in the corresponding technical field as well as in related technical fields.

The present disclosure has been described with reference to specific embodiments. However, those skilled in the art will clearly understand that various modified embodiments can be implemented within the technical scope of the present disclosure. Therefore, the embodiments disclosed above should be considered from an illustrative rather than a restrictive perspective. In other words, the true technical scope of the present disclosure is indicated by the claims, and all differences within the scope equivalent thereto should be interpreted as being included in the present disclosure.

[Explanation of reference signs]

2: vehicle
10: battery pack
100: apparatus for diagnosing a battery
110: battery profile generating unit
120: negative electrode profile obtaining unit
130: diagnostic factor obtaining unit
140: diagnosing unit
150: charge/discharge adjusting unit
160: output unit

**Claims**

1. A method for diagnosing a battery, which diagnoses a target battery having a negative electrode to which an active material that undergoes phase transformation as charge and discharge progresses is applied, the method comprising:

   generating a battery profile representing a relationship between a capacity and a voltage of the target battery for each predetermined number of charge cycles or discharge cycles;
   obtaining a negative electrode profile estimating a relationship between a negative electrode capacity and a negative electrode potential of the target battery based on the battery profile;
   obtaining a diagnostic factor value representing an available capacity per unit area of the negative electrode based on the negative electrode profile; and

diagnosing a state of the negative electrode based on diagnostic factor values sequentially obtained as the charge cycle or the discharge cycle is repeated.

2. The method for diagnosing a battery according to claim 1, further comprising, before the step of generating a battery profile:
measuring a voltage value of the target battery using a voltage sensor while the predetermined number of charge cycles or discharge cycles progress.

3. The method for diagnosing a battery according to claim 1, further comprising, before the step of obtaining a negative electrode profile:

generating a plurality of adjusted positive electrode profiles differently adjusted and a plurality of adjusted negative electrode profiles differently adjusted by adjusting a reference positive electrode profile representing a relationship between a positive electrode capacity and a positive electrode potential of a predetermined reference battery and a reference negative electrode profile representing a relationship between a negative electrode capacity and a negative electrode potential of the reference battery, respectively,
wherein the step of obtaining a negative electrode profile includes a step of selecting an adjusted positive electrode profile and an adjusted negative electrode profile corresponding to the battery profile among the plurality of adjusted positive electrode profiles and the plurality of adjusted negative electrode profiles, and obtaining the selected adjusted negative electrode profile as the negative electrode profile of the target battery.

4. The method for diagnosing a battery according to claim 1,
wherein the step of obtaining a diagnostic factor value includes a step of calculating the diagnostic factor value based on a negative electrode shrinkage ratio, which represents a degree of shrinkage of the negative electrode profile compared to a reference negative electrode profile representing a relationship between a negative electrode capacity and a negative electrode potential of a predetermined reference battery, and a predetermined reference value for the diagnostic factor.

5. The method for diagnosing a battery according to claim 1,
wherein the step of diagnosing a state of the negative electrode includes a step of diagnosing that degradation of the negative electrode is in progress when the diagnostic factor values show a trend of increasing and then decreasing for a predetermined period or longer as the charge cycle or the discharge cycle is repeated.

6. The method for diagnosing a battery according to claim 1,
wherein the step of diagnosing a state of the negative electrode includes:

determining a maximum value among the diagnostic factor values; and
diagnosing the state of the negative electrode as an abnormal state when another diagnostic factor value obtained after an acquisition time point of the diagnostic factor value corresponding to the maximum value is less than a predetermined threshold value.

7. The method for diagnosing a battery according to claim 1, further comprising, after the step of diagnosing a state of the negative electrode:
adjusting a charging condition or a discharging condition of the target battery based on the diagnosis result of the state of the negative electrode.

8. The method for diagnosing a battery according to any one of claims 1 to 7,
wherein the active material is silicon.

9. An apparatus for diagnosing a battery, which diagnoses a target battery having a negative electrode to which an active material that undergoes phase transformation as charge and discharge progresses is applied, the apparatus comprising:

a battery profile generating unit configured to generate a battery profile representing a relationship between a capacity and a voltage of the target battery for each predetermined number of charge cycles or discharge cycles;
a negative electrode profile obtaining unit configured to obtain a negative electrode profile estimating a relationship between a negative electrode capacity and a negative electrode potential of the target battery based on the battery profile;

a diagnostic factor obtaining unit configured to obtain a diagnostic factor value representing an available capacity per unit area of the negative electrode based on the negative electrode profile; and

a diagnosing unit configured to diagnose a state of the negative electrode based on diagnostic factor values sequentially obtained by the diagnostic factor obtaining unit as the charge cycle or the discharge cycle is repeated.

10. The apparatus for diagnosing a battery according to claim 9,
wherein the negative electrode profile obtaining unit includes:

a first module for generating a plurality of adjusted positive electrode profiles differently adjusted and a plurality of adjusted negative electrode profiles differently adjusted by adjusting a reference positive electrode profile representing a relationship between a positive electrode capacity and a positive electrode potential of a predetermined reference battery and a reference negative electrode profile representing a relationship between a negative electrode capacity and a negative electrode potential of the reference battery, respectively; and

a second module for selecting an adjusted positive electrode profile and an adjusted negative electrode profile corresponding to the battery profile among the plurality of adjusted positive electrode profiles and the plurality of adjusted negative electrode profiles, and obtaining the selected adjusted negative electrode profile as the negative electrode profile of the target battery.

11. The apparatus for diagnosing a battery according to claim 9,
wherein the diagnosing unit is configured to diagnose that degradation of the negative electrode is in progress when the diagnostic factor values show a trend of increasing and then decreasing for a predetermined period or longer as the charge cycle or the discharge cycle is repeated.

12. The apparatus for diagnosing a battery according to claim 9,
wherein the diagnosing unit is configured to diagnose the state of the negative electrode as an abnormal state when another diagnostic factor value obtained after an acquisition time point of a diagnostic factor value corresponding to a maximum value among the diagnostic factor values is less than a predetermined threshold value.

13. A battery pack comprising the apparatus for diagnosing a battery according to any one of claims 9 to 12.

14. A vehicle comprising the apparatus for diagnosing a battery according to any one of claims 9 to 12.

FIG. 1

```
                                                            ┌─100

┌──────────────────────────────────────────────────────────────┐
│              APPARATUS FOR DIAGNOSING BATTERY                  │
│                                                       ┌─110    │
│  ┌────────────────────────────────────────────────────────┐   │
│  │         BATTERY PROFILE OBTAINING UNIT                  │   │
│  └────────────────────────────────────────────────────────┘   │
│                                                    ┌─120       │
│  ┌────────────────────────────────────────────────────────┐   │
│  │   NEGATIVE ELECTRODE PROFILE OBTAINING UNIT   ┌─122      │   │
│  │  ┌──────────────────────────────────────────────────┐   │  │
│  │  │              FIRST MODULE                         │   │  │
│  │  └──────────────────────────────────────────────────┘   │  │
│  │                                             ┌─124        │  │
│  │  ┌──────────────────────────────────────────────────┐   │  │
│  │  │              SECOND MODULE                        │   │  │
│  │  └──────────────────────────────────────────────────┘   │  │
│  └────────────────────────────────────────────────────────┘   │
│                                                    ┌─130       │
│  ┌────────────────────────────────────────────────────────┐   │
│  │         DIAGNOSTIC FACTOR OBTAINING UNIT               │   │
│  └────────────────────────────────────────────────────────┘   │
│                                                    ┌─140       │
│  ┌────────────────────────────────────────────────────────┐   │
│  │                DIAGNOSING UNIT                          │   │
│  └────────────────────────────────────────────────────────┘   │
│          ┌─150                           ┌─160                 │
│  ┌──────────────────────┐      ┌──────────────────────────┐    │
│  │   CHARGE/DISCHARGE    │      │       OUTPUT UNIT        │    │
│  │   ADJUSTING UNIT      │      │                          │    │
│  └──────────────────────┘      └──────────────────────────┘    │
└──────────────────────────────────────────────────────────────┘
     ┌─12a        ┌─12b           ┌─14            ┌─16
┌──────────┐ ┌──────────┐    ┌──────────────┐ ┌──────────┐
│ VOLTAGE  │ │ CURRENT  │ ....│COMMUNICATION │ │ STORAGE  │
│ SENSOR   │ │ SENSOR   │    │    UNIT       │ │  UNIT    │
└──────────┘ └──────────┘    └──────────────┘ └──────────┘
```

FIG. 2

FIG. 3

FIG. 4

FIG. 5

FIG. 6

FIG. 7

FIG. 8

FIG. 9

FIG. 10

FIG. 11

```
                    ┌─────────┐
                    │  START  │
                    └────┬────┘
                         │
    ┌────────────────────▼────────────────────────────┐  ┌─S10
    │   MEASURE VOLTAGE OF TARGET BATTERY              │
    │   WHILE CHARGE OR DISCHARGE PROGRESSES           │
    └────────────────────┬────────────────────────────┘
                         │                               ┌─S20
    ┌────────────────────▼────────────────────────────┐
    │          GENERATE BATTERY PROFILE                │
    └────────────────────┬────────────────────────────┘
                         │                               ┌─S30
    ┌────────────────────▼────────────────────────────┐
    │       OBTAIN NEGATIVE ELECTRODE PROFILE          │
    └────────────────────┬────────────────────────────┘
                         │                               ┌─S40
    ┌────────────────────▼────────────────────────────┐
    │       OBTAIN AND STORE DIAGNOSTIC FACTOR         │
    └────────────────────┬────────────────────────────┘
                         │                               ┌─S50
    ┌────────────────────▼────────────────────────────┐
    │   DIAGNOSE TARGET BATTERY BASED ON               │
    │   STORED DIAGNOSTIC FACTOR VALUES                │
    └────────────────────┬────────────────────────────┘
                         │
         NO     ┌────────▼────────┐                      ┌─S60
        ◄───────│ IS TARGET BATTERY ABNORMAL? │
                └────────┬────────┘
                      YES│                                ┌─S70
    ┌────────────────────▼────────────────────────────┐
    │   ADJUST CHARGING AND/OR                         │
    │   DISCHARGING CONDITION OF TARGET BATTERY        │
    └────────────────────┬────────────────────────────┘
                         │
         NO     ┌────────▼────────┐                      ┌─S80
        ◄───────│ IS TARGET BATTERY │
                │ NO LONGER IN USE? │
                └────────┬────────┘
                      YES│
                    ┌────▼────┐
                    │   END   │
                    └─────────┘
```

FIG. 12

10

FIG. 13

# EP 4 707 838 A1

## INTERNATIONAL SEARCH REPORT

International application No.

**PCT/KR2025/000043**

| A. | CLASSIFICATION OF SUBJECT MATTER |
|---|---|

**G01R 31/396**(2019.01)i; **G01R 31/382**(2019.01)i; **G01R 31/392**(2019.01)i

According to International Patent Classification (IPC) or to both national classification and IPC

| B. | FIELDS SEARCHED |
|---|---|

Minimum documentation searched (classification system followed by classification symbols)

G01R 31/396(2019.01); G01R 19/00(2006.01); G01R 31/36(2006.01); G01R 31/367(2019.01); H01M 10/48(2006.01); H01M 4/36(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 상 변태(phase transformation), 배터리(battery), 진단(diagnosis)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | KR 10-2022-0093840 A (LG ENERGY SOLUTION, LTD.) 05 July 2022 (2022-07-05)<br>See paragraphs [0008]-[0149], claim 10 and figures 5-9. | 1-14 |
| Y | JP 2020-046420 A (TOYOTA MOTOR CORP.) 26 March 2020 (2020-03-26)<br>See paragraphs [0018]-[0046] and figure 2. | 1-14 |
| Y | KR 10-2019-0073065 A (LG CHEM, LTD.) 26 June 2019 (2019-06-26)<br>See claim 10. | 7 |
| A | KR 10-2022-0094042 A (LG ENERGY SOLUTION, LTD.) 05 July 2022 (2022-07-05)<br>See paragraphs [0032]-[0203] and figures 1-16. | 1-14 |
| A | JP 2017-190979 A (TOYOTA MOTOR CORP.) 19 October 2017 (2017-10-19)<br>See paragraphs [0014]-[0128] and figures 1-14. | 1-14 |

☐ Further documents are listed in the continuation of Box C.  ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **09 April 2025** | **09 April 2025** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

### INTERNATIONAL SEARCH REPORT
**Information on patent family members**

International application No.

**PCT/KR2025/000043**

| Patent document cited in search report | | | Publication date (day/month/year) | Patent family member(s) | | | Publication date (day/month/year) |
|---|---|---|---|---|---|---|---|
| KR | 10-2022-0093840 | A | 05 July 2022 | CN | 115380221 | A | 22 November 2022 |
| | | | | EP | 4119962 | A1 | 18 January 2023 |
| | | | | EP | 4119962 | B1 | 26 February 2025 |
| | | | | JP | 2023-515838 | A | 14 April 2023 |
| | | | | JP | 7395809 | B2 | 12 December 2023 |
| | | | | US | 12066496 | B2 | 20 August 2024 |
| | | | | US | 2023-0236262 | A1 | 27 July 2023 |
| | | | | US | 2024-0377472 | A1 | 14 November 2024 |
| | | | | WO | 2022-145776 | A1 | 07 July 2022 |
| JP | 2020-046420 | A | 26 March 2020 | CN | 110911764 | A | 24 March 2020 |
| | | | | CN | 110911764 | B | 10 January 2023 |
| | | | | US | 11209489 | B2 | 28 December 2021 |
| | | | | US | 2020-0088797 | A1 | 19 March 2020 |
| KR | 10-2019-0073065 | A | 26 June 2019 | CN | 110679056 | A | 10 January 2020 |
| | | | | CN | 110679056 | B | 09 May 2023 |
| | | | | EP | 3641095 | A1 | 22 April 2020 |
| | | | | EP | 3641095 | B1 | 19 October 2022 |
| | | | | JP | 2020-518965 | A | 25 June 2020 |
| | | | | JP | 7020706 | B2 | 16 February 2022 |
| | | | | KR | 10-2259967 | B1 | 02 June 2021 |
| | | | | US | 11397217 | B2 | 26 July 2022 |
| | | | | US | 2020-0182943 | A1 | 11 June 2020 |
| | | | | WO | 2019-124738 | A1 | 27 June 2019 |
| KR | 10-2022-0094042 | A | 05 July 2022 | CN | 115398256 | A | 25 November 2022 |
| | | | | EP | 4119963 | A1 | 18 January 2023 |
| | | | | JP | 2023-515831 | A | 14 April 2023 |
| | | | | JP | 7395808 | B2 | 12 December 2023 |
| | | | | US | 12085623 | B2 | 10 September 2024 |
| | | | | US | 2023-0160970 | A1 | 25 May 2023 |
| | | | | US | 2024-0402259 | A1 | 05 December 2024 |
| | | | | WO | 2022-145777 | A1 | 07 July 2022 |
| JP | 2017-190979 | A | 19 October 2017 | JP | 6668905 | B2 | 18 March 2020 |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020240011541